# EUROPEAN PATENT APPLICATION

(11) **EP 4 827 291 A2**
(43) Date of publication of application: **21.10.2026**
(21) Application number: 26167907.0
(22) Date of filing: 26.03.2026
(51) Int. Cl.: H10K 50/822, H10K 59/80, H10K 59/122, H10K 59/123

(54) **DISPLAY DEVICE AND ELECTRONIC DEVICE**

(30) Priority: 18.04.2025 KR 20250050676
(71) Applicant: Samsung Display Co., Ltd., Yongin-si, Gyeonggi-do (KR)
(72) Inventor: Baek, Youngseok, Yongin-si, Gyeonggi-Do (KR)
(74) Representative: Gulde & Partner

(57) **Abstract**

A display element layer includes a common electrode, a conductive barrier disposed on the common electrode and defining an outer barrier opening and an inner barrier opening, a barrier insulating layer disposed on the conductive barrier, a first electrode disposed on the barrier insulating layer and disposed in the inner barrier opening, a pixel defining layer disposed on the first electrode, where a light emitting opening is defined in the pixel defining layer to expose a portion of the first electrode, an emission pattern disposed on the first electrode and covering the pixel defining layer, a second electrode covering the emission pattern and electrically connected with the conductive barrier, a protrusion disposed on the pixel defining layer and overlapping a center of the emission pattern, and a light control layer disposed on the protrusion and covering the protrusion.

## Description

This application claims priority to Korean Patent Application No. 10-2025-0050676, filed on April 18, 2025, and all the benefits accruing therefrom under 35 U.S.C. §119, the content of which in its entirety is herein incorporated by reference.

### BACKGROUND

### (1) Field

Embodiments of the present disclosure described herein relate to a display device and an electronic device with improved display quality.

### (2) Description of the Related Art

A display device, such as a television, a monitor, a smart phone, or a tablet computer, which provides an image to a user may include a display panel that displays the image. Various display panels, such as a liquid crystal display panel, an organic light emitting display panel, an electro wetting display panel, and an electrophoretic display panel, are being developed.

The organic light emitting display panel may include an anode, a cathode, and an emission pattern. The emission pattern may be separately formed in each of light emitting areas, and the cathode may provide a common voltage to the light emitting areas.

### SUMMARY

Embodiments of the present disclosure provide a display device and an electronic device with improved display quality.

According to an embodiment, a display device includes a base layer, a circuit element layer disposed on the base layer, where the circuit element layer includes a transistor, and a display element layer disposed on the circuit element layer. In such an embodiment, the display element layer includes a common electrode disposed on the circuit element layer, a conductive barrier disposed on the common electrode, where the conductive barrier defines an outer barrier opening and an inner barrier opening, a barrier insulating layer disposed on the conductive barrier, a first electrode disposed on the barrier insulating layer and disposed in the inner barrier opening, where the first electrode is electrically connected to the transistor, a pixel defining layer disposed on the first electrode, where a light emitting opening is defined in the pixel defining layer to expose a portion of the first electrode, an emission pattern disposed on the first electrode and covering the pixel defining layer, a second electrode covering the emission pattern and electrically connected with the conductive barrier, a protrusion disposed on the pixel defining layer and overlapping a center of the emission pattern, and a light control layer disposed on the protrusion and covering the protrusion.

In an embodiment, the emission pattern may have a first refractive index, and the light control layer may have a second refractive index lower than the first refractive index.

In an embodiment, the light control layer may include a metallic material.

In an embodiment, the protrusion may include an organic material or an inorganic material.

In an embodiment, a side surface of the protrusion may be inclined with respect to an upper surface of the base layer.

In an embodiment, the protrusion may overlap the inner barrier opening in a plan view.

In an embodiment, the inner barrier opening may overlap the center of the emission pattern.

In an embodiment, the inner barrier opening may overlap the center of the first electrode.

In an embodiment, the emission pattern may cover a portion of the conductive barrier and the barrier insulating layer.

In an embodiment, the light emitting opening may have a ring shape in a plan view.

In an embodiment, the pixel defining layer may be filled in the inner barrier opening.

In an embodiment, the outer barrier opening comprises an undercut shape in the cross section.

In an embodiment, the conductive barrier defines a tip portion therein, wherein the emission pattern is patterned by the tip portion and wherein the emission pattern covers a side surface of the barrier insulating layer.

In an embodiment, the display device may further include a thin film encapsulation layer disposed on the second electrode.

According to an embodiment, a display device includes a base layer, a common electrode disposed on the base layer, a conductive barrier disposed on the common electrode, where the conductive barrier defines an inner barrier opening, a barrier insulating layer disposed on the conductive barrier, a first electrode disposed on the barrier insulating layer and disposed in the inner barrier opening, a pixel defining layer disposed on the first electrode, where a light emitting opening is defined in the pixel defining layer to expose a portion of the first electrode, an emission pattern disposed on the first electrode and covering the pixel defining layer, a second electrode covering the emission pattern and electrically connected with the conductive barrier, a protrusion disposed on the pixel defining layer and overlapping the center of the emission pattern, and a light control layer disposed on the protrusion. In such an embodiment, the emission pattern has a first refractive index, and the light control layer has a second refractive index lower than the first refractive index.

In an embodiment, the light control layer may include a metallic material.

In an embodiment, the protrusion may include an organic material or an inorganic material.

In an embodiment, a side surface of the protrusion may be inclined with respect to an upper surface of the base layer.

In an embodiment, the protrusion may overlap the inner barrier opening in a plan view.

In an embodiment, the inner barrier opening may overlap the center of the emission pattern.

In an embodiment, the light emitting opening may have a ring shape in a plan view.

In an embodiment, the pixel defining layer may be filled in the inner barrier opening.

According to an embodiment, an electronic device includes a display module and a processor which controls the display module. In such an embodiment, the display module includes a base layer, a circuit element layer disposed on the base layer, where the circuit element layer includes a transistor, and a display element layer disposed on the circuit element layer. In such an embodiment, the display element layer includes a common electrode disposed on the circuit element layer, a conductive barrier disposed on the common electrode, where the conductive barrier defines an outer barrier opening and an inner barrier opening, a barrier insulating layer disposed on the conductive barrier, a first electrode disposed on the barrier insulating layer and disposed in the inner barrier opening, where the first electrode is electrically connected to the transistor, a pixel defining layer disposed on the first electrode, where a light emitting opening is defined in the pixel defining layer to expose a portion of the first electrode, an emission pattern disposed on the first electrode and covering the pixel defining layer, a second electrode covering the emission pattern and electrically connected with the conductive barrier, a protrusion disposed on the pixel defining layer and overlapping the center of the emission pattern, and a light control layer disposed on the protrusion and covering the protrusion.

Embodiments of the invention provide a robust display device that is able to compensate for a reduced light emitting area while allowing a high resolution.

### BRIEF DESCRIPTION OF THE DRAWINGS

The above and other features of embodiments of the present disclosure will become apparent by describing in detail embodiments thereof with reference to the accompanying drawings.
FIG. 1 is a block diagram of an electronic device according to an embodiment of the present disclosure.
FIG. 2 illustrates schematic views of electronic devices according to various embodiments.
FIG. 3 is a perspective view of an electronic device according to an embodiment of the present disclosure.
FIG. 4 is an exploded perspective view of the electronic device according to an embodiment of the present disclosure.
FIG. 5 illustrates an electronic device according to an embodiment of the present disclosure.
FIG. 6 is an exploded perspective view of the electronic device according to an embodiment of the present disclosure.
FIG. 7 is a sectional view of a display module according to an embodiment of the present disclosure.
FIG. 8 is a plan view of a display panel according to an embodiment of the present disclosure.
FIG. 9 is an enlarged plan view illustrating a portion of a display area of the display panel according to an embodiment of the present disclosure.
FIG. 10 is a sectional view of the display panel taken along line I-I' of FIG. 9 according to an embodiment of the present disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

It will be understood that when an element is referred to as being "on" another element, it can be directly on the other element or intervening elements may be present therebetween. In contrast, when an element is referred to as being "directly on" another element, there are no intervening elements present.

In this specification, when a component (or an area, a layer, a part, etc.) is referred to as being "connected to" or "coupled to" another component, this means that the component may be directly connected to, or coupled to the other component or a third component may be present therebetween.

Identical reference numerals refer to identical components. Additionally, in the drawings, the thicknesses, proportions, and dimensions of components are exaggerated for effective description.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the present disclosure will be described with reference to the accompanying drawings.

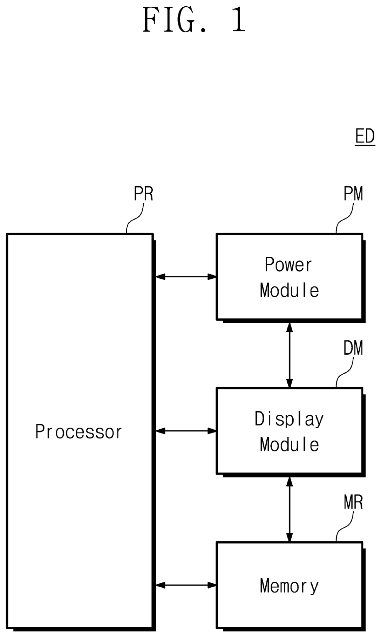

FIG. 1 is a block diagram of an electronic device according to an embodiment of the present disclosure.

The electronic device according to the present disclosure may be provided in various forms. The electronic device according to the present disclosure may further include modules or devices having other additional functions.

Referring to FIG. 1, the electronic device ED according to an embodiment may include a display module DM, a processor PR, a memory MR, and a power module PM.

The processor PR may include at least one selected from a central processing unit (CPU), an application processor (AP), a graphic processing unit (GPU), a communication processor (CP), an image signal processor (ISP), and a controller. The processor PR may control the power module PM, the display module DM, and the memory MR.

Data information required for operation of the processor PR or the display module DM may be stored in the memory MR. When the processor PR executes an application stored in the memory MR, an image data signal and/or an input control signal may be transferred to the display module DM, and the display module DM may process the provided signal and may output image information through a display screen.

The power module PM may include a power supply module such as a power adapter or a battery device and a power conversion module that converts power supplied by the power supply module and generates power used for operation of the electronic device ED.

The display module DM may operate in response to an electrical signal. Some of the separate modules functionally included in one module may be included in the display module DM, and the others may be provided in the electronic device ED separately from the display module DM.

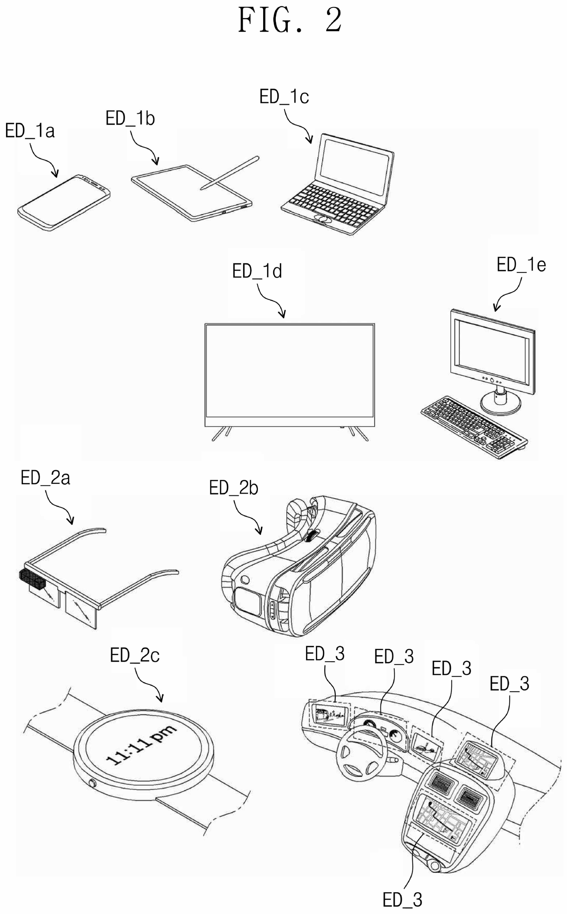

FIG. 2 illustrates schematic views of electronic devices according to various embodiments.

Referring to FIG. 2, the electronic devices according to the various embodiments may include not only electronic devices for displaying an image, such as a smart phone ED_1a, a tablet personal computer (PC) ED_1b, a laptop computer ED_1c, a television (TV) ED_1d, and a desk monitor ED_1e, but also wearable electronic devices including a display module, such as smart glasses ED_2a, a head mounted display ED_2b, and a smart watch ED_2c.

In addition, the electronic devices according to the various embodiments may be applied to the inside of a transport device such as a vehicle and may provide various pieces of information to a user through images. In an embodiment, for example, the electronic device according to the present disclosure may be provided in the form of vehicle electronic devices ED_3 including a display module, such as center information displays (CID) disposed on an instrument panel, a center fascia, and a dashboard of a vehicle and a room mirror display.

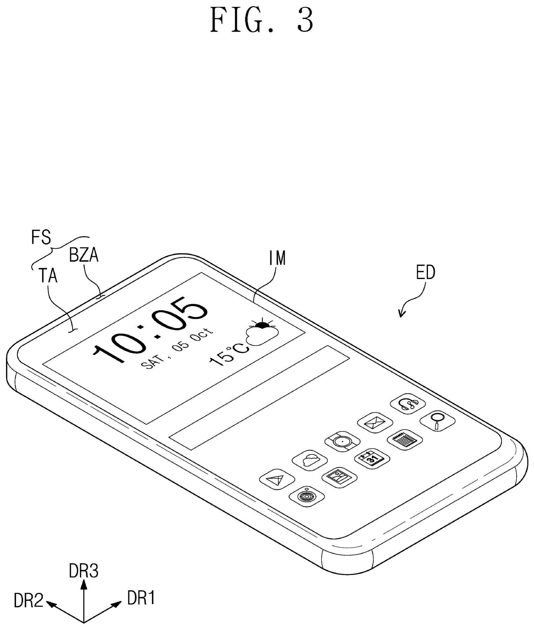

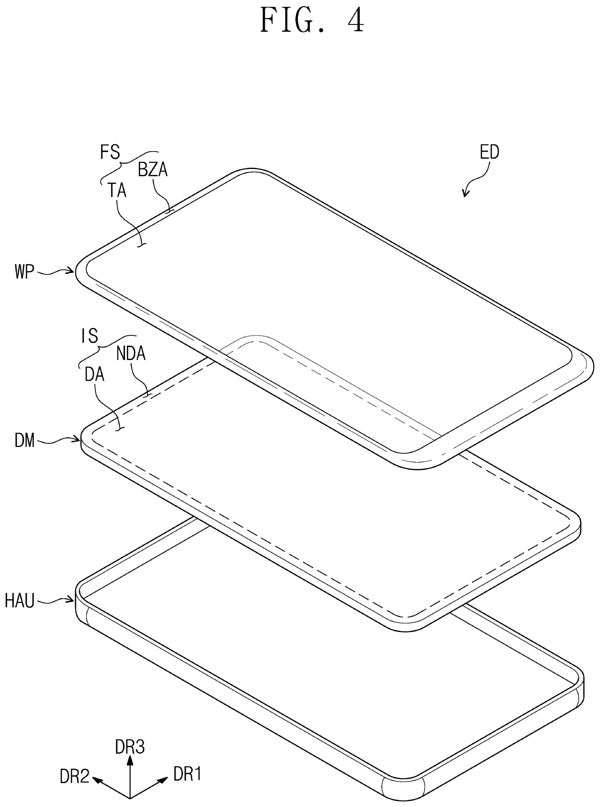

FIG. 3 is a perspective view of an electronic device according to an embodiment of the present disclosure, and FIG. 4 is an exploded perspective view of the electronic device according to an embodiment of the present disclosure.

Referring to FIGS. 3 and 4, in an embodiment, the electronic device ED may be a large electronic device such as a television, a monitor, or a billboard. Alternatively, the electronic device ED may be a small or medium-sized electronic device such as a PC, a notebook computer, a personal digital assistant (PDA), a car navigation unit, a game machine, a smart phone, a tablet computer, or a camera. However, this is illustrative, and the electronic device ED may be employed as another display device without departing from the scope of the present disclosure. In FIGS. 3 and 4, an embodiment where the electronic device ED is a smart phone is illustrated as an example.

In an embodiment, the electronic device ED may display an image IM in a third direction DR3 through a display surface FS parallel to a first direction DR1 and a second direction DR2. The image IM may include a still image as well as a dynamic image. In FIG. 3, a clock window and icons are illustrated as an example of the image IM. The display surface FS through which the image IM is displayed may correspond to the front surface of the electronic device ED.

In such an embodiment, front surfaces (or upper surfaces) and rear surfaces (or lower surfaces) of members are defined based on the direction in which the image IM is displayed. The front surfaces and the rear surfaces may be opposite each other in the third direction DR3, and the normal directions of the front surfaces and the rear surfaces may be parallel to the third direction DR3. In the disclosure, the directions indicated by the first to third directions DR1, DR2, and DR3 may be relative concepts and may be changed to other directions. The expression "when viewed from above a plane" or "in a plan view" used herein may mean that it is viewed in the third direction DR3.

In an embodiment, the electronic device ED may include a window WP, a display module DM, and a housing HAU. The window WP and the housing HAU may be coupled with each other to form the exterior of the electronic device ED.

The window WP may include an optically clear insulating material. In an embodiment, for example, the window WP may include glass or plastic. The front surface of the window WP may define the display surface FS of the electronic device ED. The display surface FS may include a transmissive area TA and a bezel area BZA. The transmissive area TA may be an optically clear area. In an embodiment, for example, the transmissive area TA may be an area having a visible light transmittance of about 90% or greater.

The bezel area BZA may be an area having a lower light transmittance than the transmissive area TA. The bezel area BZA may define the shape of the transmissive area TA. The bezel area BZA may be adjacent to the transmissive area TA and may surround the transmissive area TA. However, this is illustrative, and the bezel area BZA of the window WP may be omitted in another embodiment. The window WP may include at least one functional layer among an anti-fingerprint layer, a hard coating layer, and an anti-reflective layer, but is not limited to any one embodiment.

The display module DM may be disposed under the window WP. The display module DM may be a component that substantially generates the image IM. The image IM generated by the display module DM is displayed on a display surface IS of the display module DM and visually recognized by a user from the outside through the transmissive area TA.

The display module DM may include a display area DA and a non-display area NDA. The display area DA may be an area activated in response to an electrical signal. The non-display area NDA may be adjacent to the display area DA. The non-display area NDA may surround the display area DA. The non-display area NDA may be an area covered by the bezel area BZA and may not be visible from the outside.

The housing HAU may be coupled with the window WP. The housing HAU may be coupled with the window WP to provide an inner space. The display module DM may be accommodated in the inner space.

The housing HAU may include a material having relatively high rigidity. In an embodiment, for example, the housing HAU may include a plurality of frames and/or plates including or made of glass, plastic, or metal, or a combination thereof. The housing HAU may stably protect the components of the electronic device ED accommodated in the inner space from external impact.

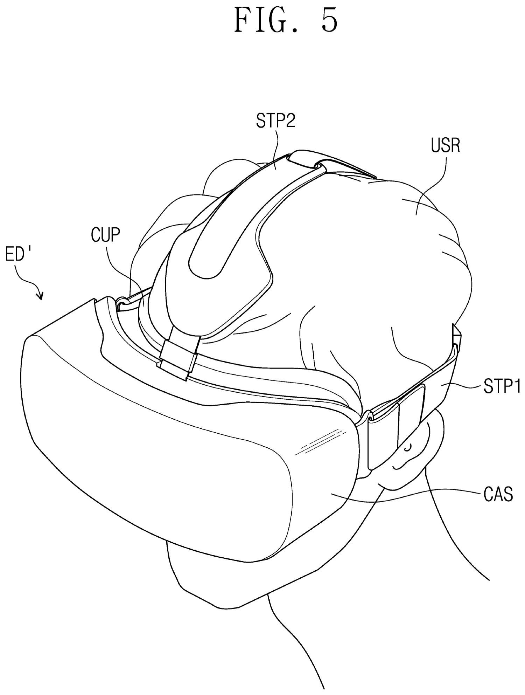

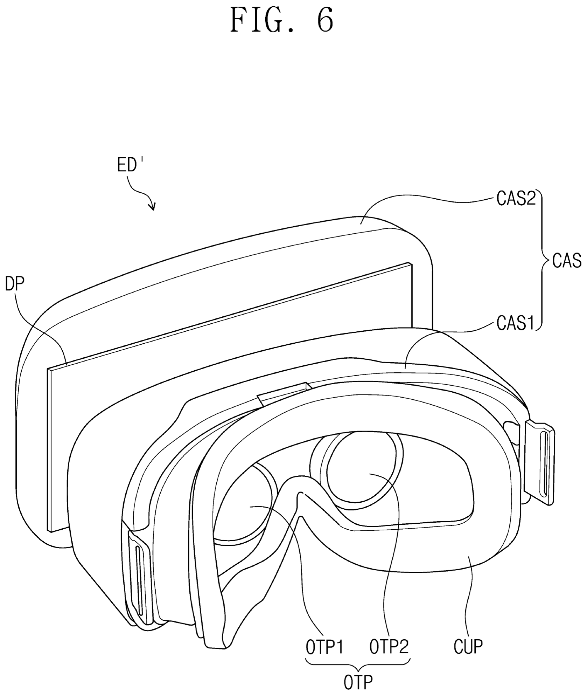

FIG. 5 illustrates an electronic device according to an embodiment of the present disclosure, and FIG. 6 is an exploded perspective view of the electronic device according to an embodiment of the present disclosure.

Referring to FIGS. 5 and 6, an embodiment of the electronic device ED' may be defined as a head-mounted electronic device. The electronic device ED' may be worn on the head of a user USR.

The electronic device ED' may block a peripheral view of the user USR and may provide an image to the user USR. The electronic device ED' may provide virtual reality to the user USR.

The electronic device ED' may include a display panel DP, a casing CAS, a cushion CUP, and straps STP1 and STP2. The casing CAS may be worn on the user USR. The display panel DP that displays an image and an acceleration sensor (not illustrated) may be accommodated in the casing CAS.

The acceleration sensor may sense a movement of the user USR and may transfer a certain signal to the display panel DP. Accordingly, the display panel DP may provide an image corresponding to a change in the gaze of the user USR. Thus, the user USR may experience virtual reality similar to actual reality.

The cushion CUP may be disposed between the casing CAS and the user USR. The cushion CUP may include a material capable of being deformed. In an embodiment, for example, the cushion CUP may include a polymer resin (e.g., polyurethane, polycarbonate, polypropylene, or polyethylene). Alternatively, the cushion CUP may include a sponge formed by causing liquid rubber, a urethane-based material, or an acrylic material to foam.

The cushion CUP may bring the casing CAS into close contact with the user USR to improve the wearing comfort of the user USR. The cushion CUP may be detachable from the casing CAS.

The straps STP1 and STP2 may be coupled with the casing CAS to enable the casing CAS to be easily worn on the user USR. The straps STP1 and STP2 may include the first strap STP1 and the second strap STP2.

The first strap STP1 may be worn along the circumference of the head of the user USR. The first strap STP1 may fix the casing CAS to the user USR to bring the casing CAS into close contact with the head of the user USR.

The second strap STP2 may connect the casing CAS and the first strap STP1 along the upper part of the head of the user USR. The second strap STP2 may prevent the casing CAS from slipping down.

The casing CAS may include a first casing CAS1 and a second casing CAS2. The first casing CAS1 and the second casing CAS2 may be separated from each other.

The display panel DP may be disposed between the first casing CAS1 and the second casing CAS2. The first casing CAS1 and the second casing CAS2 may be coupled with each other, and accordingly the display panel DP may be accommodated in the casing CAS. In an embodiment, for example, the display panel DP may provide a left eye image and a right eye image to the user USR. Accordingly, the display panel DP may provide a stereoscopic image to the user USR.

An optical system OTP may be disposed in the first casing CAS1. The optical system OTP may magnify an image provided from the display panel DP. The optical system OTP may be disposed between the display panel DP and the eyes of the user USR. The optical system OTP may include a left-eye optical system OTP1 and a right-eye optical system OTP2. The left-eye optical system OTP1 may magnify and provide the image to the left pupil of the user USR, and the right-eye optical system OTP2 may magnify and provide the image to the right pupil of the user USR.

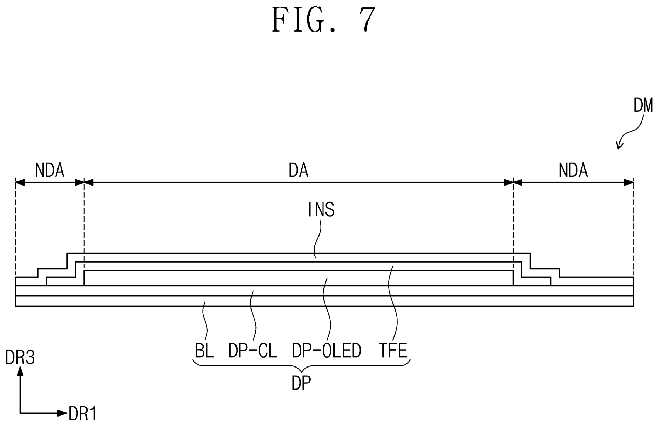

FIG. 7 is a sectional view of the display module according to an embodiment of the present disclosure.

Referring to FIG. 7, an embodiment of the display module DM may include a display panel DP and an input sensor INS. Although not separately illustrated, the electronic device ED (refer to FIG. 1) according to an embodiment of the present disclosure may further include a protective member disposed on the lower surface of the display panel DP or an anti-reflective member and/or a window disposed on the upper surface of the input sensor INS.

In an embodiment, the display panel DP may be an emissive display panel. However, this is illustrative, and the present disclosure is not particularly limited thereto. In an embodiment, for example, the display panel DP may be an organic light emitting display panel or an inorganic light emitting display panel. A light emitting layer in the organic light emitting display panel may include an organic luminescent material. A light emitting layer in the inorganic light emitting display panel may include a quantum dot, a quantum rod, a micro-light emitting diode (LED), or a nano-LED. Hereinafter, for convenience of description, embodiments where the display panel DP is an organic light emitting display panel will be mainly described.

In an embodiment, the display panel DP may include a base layer BL, and a circuit element layer DP-CL, a display element layer DP-OLED, and a thin film encapsulation layer TFE that are disposed on the base layer BL. The input sensor INS may be directly disposed on the thin film encapsulation layer TFE. The expression "component A is directly disposed on component B" used herein means that an adhesive layer is not disposed between component A and component B.

The base layer BL may include at least one plastic film. The base layer BL may include a plastic substrate, a glass substrate, a metal substrate, or an organic/inorganic composite substrate as a flexible substrate. The display area DA and the non-display area NDA described with reference to FIG. 4 may be identically defined in the base layer BL.

The circuit element layer DP-CL may include at least one insulating layer and a circuit element. The insulating layer includes at least one inorganic layer and at least one organic layer. The circuit element includes signal lines and a pixel driving circuit.

The display element layer DP-OLED may include a conductive barrier and a light emitting element. The light emitting element may include an anode, an emission pattern, and a cathode. Description thereabout will be given below.

The thin film encapsulation layer TFE may include a plurality of thin films. Some of the thin films may be disposed to improve optical efficiency, and the others may be disposed to protect organic light emitting diodes.

The input sensor INS obtains coordinate information of an external input. The input sensor INS may have a multi-layer structure. The input sensor INS may include a single conductive layer or a plurality of conductive layers. In addition, the input sensor INS may include a single insulating layer or a plurality of insulating layers. The input sensor INS may sense the external input in a capacitive type. However, this is illustrative, and the present disclosure is not limited thereto. For example, in an embodiment, the input sensor INS may sense the external input by an electromagnetic induction method or a pressure sensing method. In another embodiment of the present disclosure, the input sensor INS may be omitted.

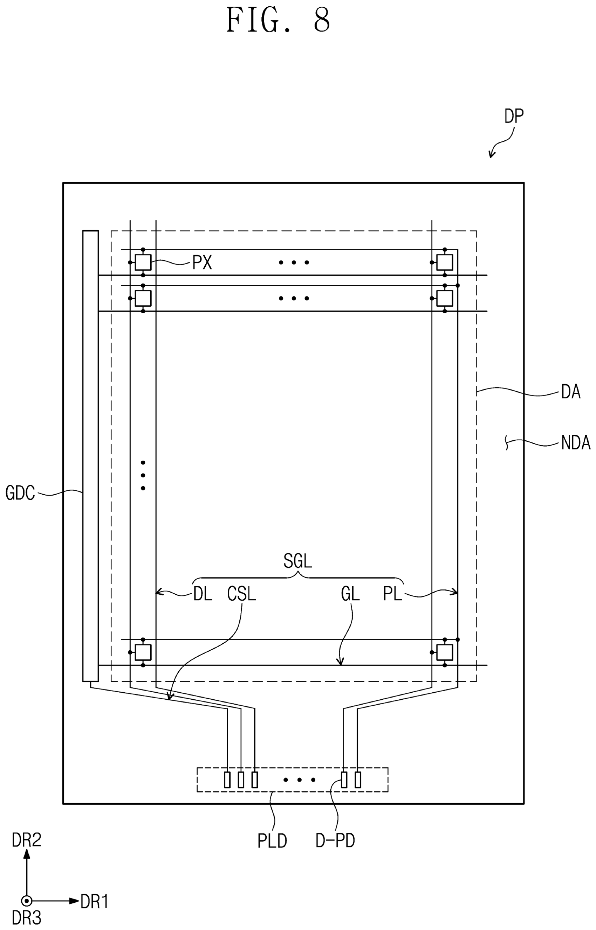

FIG. 8 is a plan view of the display panel according to an embodiment of the present disclosure.

Referring to FIG. 8, in an embodiment, a display area DA and a non-display area NDA around the display area DA may be defined in the display panel DP. The display panel DP may include pixels PX and signal lines SGL electrically connected to the pixels PX. The display panel DP may include a driving circuit GDC and a pad part PLD. The display area DA and the non-display area NDA may be distinguished from each other depending on whether the pixels PX are disposed or not. The pixels PX may be disposed in the display area DA. The driving circuit GDC and the pad part PLD may be disposed in the non-display area NDA.

The pixels PX may be arranged in the first direction DR1 and the second direction DR2. The pixels PX may include a plurality of pixel rows that extend in the first direction DR1 and that are arranged in the second direction DR2 and a plurality of pixel columns that extend in the second direction DR2 and that are arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC and may provide control signals to the driving circuit GDC.

The driving circuit GDC may include a gate driver circuit. The gate driver circuit may generate gate signals and may sequentially output the generated gate signals to the gate lines GL. The gate driver circuit may further output another control signal to a pixel driving circuit.

The pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected with a corresponding signal line among the signal lines SGL. The pixel pads D-PD may be connected to corresponding pixels PX through the signal lines SGL. In addition, one pixel pad among the pixel pads D-PD may be connected to the driving circuit GDC.

In addition, the pad part PLD may further include input pads. The input pads may be pads for connecting the flexible circuit board to the input sensor INS (refer to FIG. 7). However, without being limited thereto, the input pads may be disposed in the input sensor INS (refer to FIG. 7) and may be connected with the pixel pads D-PD and a separate circuit board. Alternatively, the input sensor INS (refer to FIG. 7) may be omitted, and the input pads may not be further included.

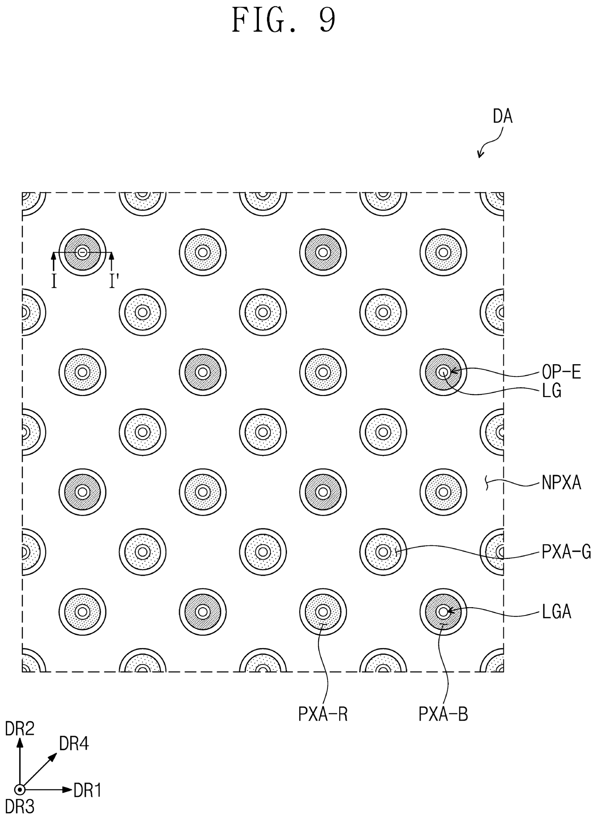

FIG. 9 is an enlarged plan view illustrating a portion of the display area of the display panel according to an embodiment of the present disclosure.

Referring to FIG. 9, in an embodiment, the display area DA may include first to third light emitting areas PXA-R, PXA-G, PXA-B and a peripheral area NPXA surrounding the first to third light emitting areas PXA-R, PXA-G, PXA-B. The first to third light emitting areas PXA-R, PXA-G, PXA-B may correspond to areas where light provided from light emitting elements is emitted. The first to third light emitting areas PXA-R, PXA-G, PXA-B may be distinguished from one another depending on the colors of light emitted toward the outside of the display panel DP (refer to FIG. 8).

The first to third light emitting areas PXA-R, PXA-G, PXA-B may provide light of first to third colors different from one another. In an embodiment, for example, the light of the first color may be red light, the light of the second color may be green light, and the light of the third color may be blue light. However, examples of the light of the first to third colors are not necessarily limited to the aforementioned examples.

Each of the first to third light emitting areas PXA-R, PXA-G, and PXA-B may be defined as an area where the upper surface of an anode is exposed by a light emitting opening OP-E. The peripheral area NPXA may set the boundaries between the first to third light emitting areas PXA-R, PXA-G, PXA-B and may effectively prevent color mixing between the first to third light emitting areas PXA-R, PXA-G, PXA-B.

Each of the first to third light emitting areas PXA-R, PXA-G, and PXA-B may be provided in plural and may be repeatedly disposed while having a certain arrangement form in the display area DA. In an embodiment, for example, the first light emitting areas PXA-R and the third light emitting areas PXA-B may alternate with one another in the first direction DR1 to form a "first group". The second light emitting areas PXA-G may be arranged in the first direction DR1 to form a "second group". Each of the "first group" and the "second group" may be provided in plural. The "first groups" and the "second groups" may alternately arranged with one another in the second direction DR2.

One second light emitting area PXA-G may be spaced apart from one first light emitting area PXA-R or one third light emitting area PXA-B in a fourth direction DR4. The fourth direction DR4 may be defined as a direction between the first direction DR1 and the second direction DR2.

FIG. 9 illustrates an example of the arrangement form of the first to third light emitting areas PXA-R, PXA-G, and PXA-B, but the first to third light emitting areas PXA-R, PXA-G, and PXA-B are not limited thereto and may be arranged in various forms. In an embodiment, as illustrated in FIG. 4, the first to third light emitting areas PXA-R, PXA-G, and PXA-B may have a PENTILE^{™} arrangement form. Alternatively, the first to third light emitting areas PXA-R, PXA-G, and PXA-B may have a stripe arrangement form or a Diamond Pixel^{™} arrangement form.

The first to third light emitting areas PXA-R, PXA-G, and PXA-B may have various shapes when viewed from above the plane or in a plan view (i.e., when viewed in the third direction DR3). In an embodiment, for example, the first to third light emitting areas PXA-R, PXA-G, and PXA-B may have a ring shape, a polygonal shape, a circular shape, or an oval shape. FIG. 9 illustrates an embodiment where the first to third light emitting areas PXA-R, PXA-G, and PXA-B have a ring shape. The ring shape may be referred to as an annular structure or a donut shape. In an embodiment, for example, the ring shape may be defined as an area between an inner circle and an outer circle having a radius greater than the radius of the inner circle.

That is, when viewed from above the plane or in a plan view, the light emitting opening OP-E may have a ring shape.

When viewed from above the plane or in a plan view, the first to third light emitting areas PXA-R, PXA-G, and PXA-B may have a same shape as each other, or at least some of the first to third light emitting areas PXA-R, PXA-G, and PXA-B may have different shapes from each other. FIG. 9 illustrates an embodiment where the first to third light emitting areas PXA-R, PXA-G, and PXA-B have a same shape as each other when viewed from above the plane or in a plan view, but the first to third light emitting areas PXA-R, PXA-G, and PXA-B are not limited thereto. In another embodiment, for example, when viewed from above the plane or in a plan view, the first light emitting area PXA-R and the third light emitting area PXA-B may have a same shape as each other, and the second light emitting area PXA-G may have a shape different from the shape of the first light emitting area PXA-R and the third light emitting area PXA-B.

A light extraction area LGA may be adjacent to the first to third light emitting areas PXA-R, PXA-G, and PXA-B. The light extraction area LGA may correspond to the inner circle of each of the first to third light emitting areas PXA-R, PXA-G and PXA-B. Each of the first to third light emitting areas PXA-R, PXA-G, and PXA-B may surround the light extraction area LGA.

The light output from the first to third light emitting areas PXA-R, PXA-G, and PXA-B may be reflected in the third direction DR3 in the light extraction area LGA. Description thereabout will be given below.

Although FIG. 9 illustrates an embodiment where the first to third light emitting areas PXA-R, PXA-G, and PXA-B have a same area as each other when viewed from above the plane or in a plan view, the present disclosure is not limited thereto, and in another embodiment, at least some of the first to third light emitting areas PXA-R, PXA-G, and PXA-B may have different areas when viewed from above the plane or in a plan view. In an embodiment, the area of the first light emitting area PXA-R that emits red light may be greater than the area of the second light emitting area PXA-G that emits green light and may be smaller than the area of the third light emitting area PXA-B that emits blue light.

In embodiments of the present disclosure, the shapes, areas, and arrangement of the first to third light emitting areas PXA-R, PXA-G, and PXA-B may be designed in various ways depending on the colors of emitted light or the size and configuration of the display panel DP (refer to FIG. 8) and are not limited to the embodiment illustrated in FIG. 9.

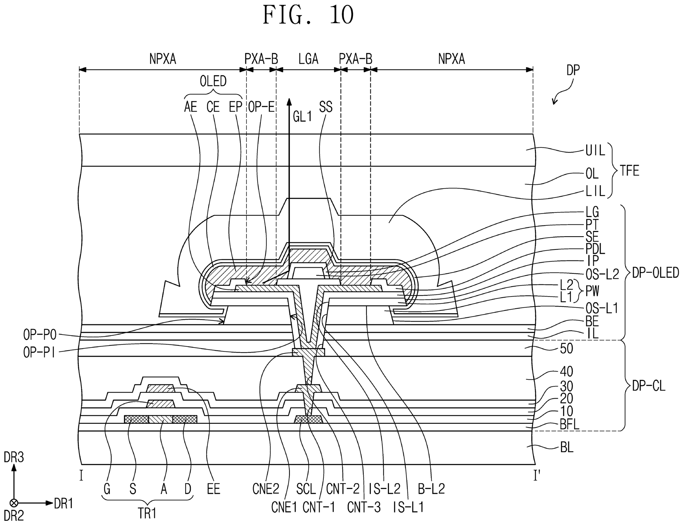

FIG. 10 is a sectional view of the display panel taken along line I-I' of FIG. 9 according to an embodiment of the present disclosure. In describing FIG. 10, the same or like components as those described with reference to FIG. 7 will be assigned with the same or like reference characters, and any repetitive detailed description thereof will be omitted.

FIG. 10 illustrates an enlarged view of the third light emitting area PXA-B in the display area DA (refer to FIG. 9), and the third light emitting area PXA-B of FIG. 10 may be identically applied to the first light emitting area PXA-R and the second light emitting area PXA-G of FIG. 9.

Referring to FIG. 10, in an embodiment, the display panel DP may include the base layer BL, the circuit element layer DP-CL, the display element layer DP-OLED, and the thin film encapsulation layer TFE.

The display panel DP may include a plurality of insulating layers, a semiconductor pattern, a conductive pattern, and a signal line. In an embodiment, an insulating layer, a semiconductor layer, and a conductive layer are formed by coating or deposition. Thereafter, the insulating layer, the semiconductor layer, and the conductive layer may be selectively subjected to patterning by photolithography and etching. In this way, the semiconductor pattern, the conductive pattern, and the signal line included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmission area (or a signal transmission line) SCL, first to fifth insulating layers 10, 20, 30, 40, and 50, an electrode EE, and a plurality of connecting electrodes CNE1 and CNE2.

The buffer layer BFL may be disposed on the base layer BL. The buffer layer BFL may improve the coupling force between the base layer BL and a semiconductor pattern. The buffer layer BFL may include a silicon oxide layer and a silicon nitride layer. The silicon oxide layer and the silicon nitride layer may be alternately stacked in the buffer layer BFL.

The semiconductor pattern may be disposed on the buffer layer BFL. The semiconductor pattern may include poly silicon. However, without being limited thereto, the semiconductor pattern may include amorphous silicon or metal oxide. FIG. 10 illustrates only a portion of the semiconductor pattern, and the semiconductor pattern may be additionally disposed in the display area DA (refer to FIG. 9). The semiconductor pattern may be arranged according to a specific rule across the display area DA (refer to FIG. 9). The semiconductor pattern may have different electrical properties depending on whether doping is performed or not. The semiconductor pattern may include a first area having a high doping concentration and a second area having a low doping concentration. The first area may be doped with an N-type dopant or a P-type dopant. A P-type transistor may include a first area doped with a P-type dopant.

The first area has a higher conductivity than the second area and substantially serves as an electrode or a signal line. The second area may substantially correspond to an active area (or a channel) of a transistor. In other words, a portion of the semiconductor pattern may be the active area of the transistor, another portion may be a source or drain of the transistor, and the rest portion may be a conductive area.

The source S, the active area A, and the drain D of the transistor TR1 may be formed from the semiconductor pattern. In FIG. 10, an embodiment where a portion of the signal transmission area SCL formed from the semiconductor pattern is illustrated. Although not separately illustrated, the signal transmission area SCL may be connected to the drain D of the transistor TR1 when viewed from above the plane or in a plan view.

The first to fifth insulating layers 10, 20, 30, 40, and 50 may be disposed on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S, the active area A, and the drain D of the transistor TR1 and the signal transmission area SCL that are disposed on the buffer layer BFL. A gate G of the transistor TR1 may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

The first connecting electrode CNE1 may be disposed on the third insulating layer 30. The first connecting electrode CNE1 may be connected to the signal transmission area SCL through a contact hole CNT-1 that penetrates (or is defined through) the first insulating layer 10, the second insulating layer 20, and the third insulating layer 30. The fourth insulating layer 40 may be disposed on the third insulating layer 30 and may cover the first connecting electrode CNE1. The fourth insulating layer 40 may be an organic layer.

The second connecting electrode CNE2 may be disposed on the fourth insulating layer 40. The second connecting electrode CNE2 may be connected to the first connecting electrode CNE1 through a contact hole CNT-2 that penetrates (or is defined through) the fourth insulating layer 40. The fifth insulating layer 50 may be disposed on the fourth insulating layer 40 and may cover the second connecting electrode CNE2. The fifth insulating layer 50 may be an organic layer. A contact hole CNT-3 penetrating the fifth insulating layer 50 may be defined in the fifth insulating layer 50. A first electrode AE to be described below may be connected to the second connecting electrode CNE2 through the contact hole CNT-3.

The display element layer DP-OLED may be disposed on the circuit element layer DP-CL. The display element layer DP-OLED may include an insulating film IL, a common electrode BE, a conductive barrier PW, a barrier insulating layer IP, a light emitting element OLED, and an auxiliary electrode SE.

The insulating film IL may be disposed on the circuit element layer DP-CL. In an embodiment, the insulating film IL may be disposed on the fifth insulating layer 50 and may cover the fifth insulating layer 50.

The common electrode BE may be disposed on the insulating film IL. In an embodiment, for example, the common electrode BE may be disposed on the circuit element layer DP-CL. The common electrode BE may be commonly disposed across the entire display area DA (refer to FIG. 9) and may provide a common voltage. In an embodiment, for example, the common electrode BE may be disposed to overlap the entire third light emitting area PXA-B.

The conductive barrier PW may be disposed on the common electrode BE. The conductive barrier PW may have an inner barrier opening OP-PI and an outer barrier opening OP-PO. The inner barrier opening OP-PI may be an opening for connecting the first electrode AE to the second connecting electrode CNE2, and the outer barrier opening OP-PO may be an opening for making an emission pattern EP and a second electrode CE subject to patterning without a fine metal mask (FMM).

The inner barrier opening OP-PI may overlap the center of the first electrode AE and the center of the emission pattern EP, and the outer barrier opening OP-PO may not overlap the center of the first electrode AE and the center of the emission pattern EP.

The outer barrier opening OP-PO of the conductive barrier PW may have an undercut shape in the cross-section. The conductive barrier PW may include a plurality of layers sequentially stacked one above another, and at least one layer among the plurality of layers may be recessed when compared to the other layers. Accordingly, the conductive barrier PW may include a tip portion. Although one undercut shape is illustrated as an example in FIG. 10, the shape of the outer barrier opening OP-PO is not limited thereto. In an embodiment, for example, the outer barrier opening OP-PO may have two or more undercut shapes.

The conductive barrier PW may include a first barrier layer L1 and a second barrier layer L2. The first barrier layer L1 may be disposed on the common electrode BE, and the second barrier layer L2 may be disposed on the first barrier layer L1. In an embodiment, as illustrated in FIG. 10, the thickness of the first barrier layer L1 may be greater than the thickness of the second barrier layer L2, but is not limited thereto. Furthermore, although FIG. 10 illustrates an embodiment where each of the common electrode BE, the first barrier layer L1, and the second barrier layer L2 is a single layer, the present disclosure is not limited thereto. In another embodiment, for example, each of the common electrode BE, the first barrier layer L1, and the second barrier layer L2 may be constituted by two or more layers.

A first inner surface IS-L1 of the first barrier layer L1 and a second inner surface IS-L2 of the second barrier layer L2 that define the inner barrier opening OP-PI may be aligned with each other. That is, the inner barrier opening OP-PI may be an opening formed by the continuous inner surfaces (S-L1 and IS-L2 rather than a protruding shape.

The first barrier layer L1 may be relatively recessed with respect to the peripheral area NPXA when compared to the second barrier layer L2. The first barrier layer L1 may be undercut with respect to the second barrier layer L2. The portion of the second barrier layer L2 that protrudes from the first barrier layer L1 toward the center of the outer barrier opening OP-PO may be defined as a tip portion within the conductive barrier PW.

The outer barrier opening OP-PO may include a first area defined by a first outer surface OS-L1 of the first barrier layer L1 and a second area defined by a second outer surface OS-L2 of the second barrier layer L2. The width of the first area may be different from the width of the second area. In an embodiment, for example, the second area may have a greater length in one direction than the first area. The one direction may be perpendicular to a thickness direction of the circuit element layer DP-CL (e.g., the third direction DR3). The one direction may be the first direction DR1 or the second direction DR2. That is, the second area of the outer barrier opening OP-PO may be an area that defines the tip portion. Due to the protruding tip portion, the second area may have a greater width than the first area.

The first barrier layer L1, the second barrier layer L2, and the common electrode BE may each include a conductive material. In an embodiment, for example, the conductive material may include metal, transparent conductive oxide (TCO), an organic material, an inorganic material, or a combination thereof. In an embodiment, for example, the metal may include gold (Au), silver (Ag), aluminum (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminum zinc oxide. The inorganic material may include silicon nitride (SiNx) or silicon oxy nitride (SiON). The barrier layer including the inorganic material may have a refractive index of about 1.3 to about 2.3.

In an embodiment of the present disclosure, the second barrier layer L2 may include a same material as the common electrode BE, and the first barrier layer L1 and the second barrier layer L2 may include different materials from each other. However, this is illustrative, and the present disclosure is not limited thereto.

In an embodiment, each of the inner surfaces IS-L1 and IS-L2 or the outer surfaces OS-L1 and OS-L2 of the conductive barrier PW is substantially perpendicular to the upper surface of the common electrode BE, the present disclosure is not limited thereto. In another embodiment, for example, the conductive barrier PW may have a tapered shape or an inverted tapered shape on a cross-section as shown in FIG. 10.

The barrier insulating layer IP may be disposed on the conductive barrier PW. The barrier insulating layer IP disposed on the conductive barrier PW may effectively prevent the conductive barrier PW and the first electrode AE (or the first electrode) from being electrically connected. The barrier insulating layer IP may cover the side surfaces of the conductive barrier PW, the common electrode BE, and side surfaces of the insulating film IL that define the inner barrier opening OP-PI.

The light emitting element OLED may include the first electrode AE (or the anode), the emission pattern EP, and the second electrode CE (or the cathode).

The first electrode AE may be disposed on the barrier insulating layer IP and may be disposed in the inner barrier opening OP-PI. On the cross-section, the first electrode AE may be disposed between the common electrode BE and the second electrode CE to be described below. The first electrode AE may be disposed on the barrier insulating layer IP and may be connected to the second connecting electrode CNE2 by making contact with the contact hole CNT-3 that is not covered by the barrier insulating layer IP. Accordingly, the first electrode AE may be electrically connected to the signal transmission area SCL through the first connecting electrode CNE1 and the second connecting electrode CNE2 and may be electrically connected to a corresponding circuit element (e.g., the transistor TR1).

The first electrode AE may be a transmissive electrode, a transflective electrode, or a reflective electrode. The first electrode AE may include a single-layer structure or a multi-layer structure. The first electrode AE may include a plurality of layers including indium tin oxide (ITO) and Ag. In an embodiment, for example, the first electrode AE may include a layer including ITO (hereinafter, referred to as the lower ITO layer), a layer that is disposed on the lower ITO layer and that includes Ag (hereinafter, referred to as the Ag layer), and a layer that is disposed on the Ag layer and that includes ITO (hereinafter, referred to as the upper ITO layer).

The emission pattern EP may be disposed on the first electrode AE. The emission pattern EP may include a light emitting layer including a luminescent material. The emission pattern EP may further include a hole injection layer (HIL) and a hole transport layer (HTL) disposed between the first electrode AE and the light emitting layer and may further include an electron transport layer (ETL) and an electron injection layer (EIL) disposed on the light emitting layer. The emission pattern EP may be referred to as an "organic layer" or an "intermediate layer".

The emission pattern EP may be patterned by the tip portion defined within the conductive barrier PW. The emission pattern EP may be disposed on the first electrode AE to cover a portion of the conductive barrier PW and the barrier insulating layer IP. In an embodiment, for example, the emission pattern EP may be patterned by the tip portion defined within the conductive barrier PW and may cover the side surface of the barrier insulating layer IP and at least a portion of the second outer surface OS-L2 of the second barrier layer L2.

According to an embodiment of the present disclosure, the emission pattern EP may be patterned and deposited on a pixel-by-pixel basis by the tip portion defined within the conductive barrier PW. That is, the emission pattern EP may be commonly formed using an open mask, but may be easily divided on a pixel-by-pixel basis by the conductive barrier PW.

In a conventional display panel, where the emission pattern EP is patterned using a fine metal mask (FMM), a support spacer protruding from the conductive barrier is desired to be provided to support the fine metal mask. Furthermore, since the fine metal mask is spaced, by the height of the barrier and the spacer, apart from a base surface on which the patterning is performed, there may be a limitation in the implementation of high resolution. In addition, since the fine metal mask is brought into contact with the spacer, foreign matter may remain on the spacer after the patterning process of the emission pattern EP, or the spacer may be damaged by a dent defect of the fine metal mask. Therefore, a defective display panel may be formed.

According to an embodiment, since the conductive barrier PW is included, the physical separation between the light emitting elements OLED of the plurality of pixels PX (refer to FIG. 8) may be easily performed. Accordingly, current leakage or a driving error between the adjacent first to third light emitting areas PXA-R, PXA-G, and PXA-B (refer to FIG. 9) may be effectively prevented, and the light emitting elements OLED of the plurality of pixels PX (refer to FIG. 8) may be independently driven.

In such an embodiment, by making the emission pattern EP subject to patterning without a mask brought into contact with an internal component in the display area DA (refer to FIG. 9), a defect rate may be reduced, and thus the display panel DP with improved process reliability may be provided. Since patterning may be effectively performed even though the separate support spacer protruding from the conductive barrier PW is not provided, the areas of the first to third light emitting areas PXA-R, PXA-G, and PXA-B (refer to FIG. 9) may be scaled down, and thus the display panel DP capable of easily implementing high resolution may be provided.

Furthermore, in the manufacture of the large-area display panel DP, the manufacture of a large-area mask may be omitted. Accordingly, process costs may be reduced, and the display panel DP may not be affected by defects that are likely to occur in the large-area mask. Thus, the display panel DP with improved process reliability may be provided.

The emission pattern EP may have a first refractive index. The first refractive index may range from about 1.6 to about 1.9. In an embodiment, for example, the first refractive index may be about 1.9.

The second electrode CE may be patterned by the tip portion defined within the conductive barrier PW. The second electrode CE may cover at least a portion of the emission pattern EP. The second electrode CE may be electrically connected with the conductive barrier PW through the auxiliary electrode SE to be described below.

The second electrode CE may include a conductive material. The second electrode CE may include or be formed of at least one selected from various materials, such as metal, transparent conductive oxide (TCO), and a conductive polymer material, as long as the second electrode CE is capable of having conductivity. In an embodiment, for example, the second electrode CE may include silver (Ag), magnesium (Mg), lead (Pb), copper (Cu), or a compound thereof. The second electrode CE may be electrically connected with the conductive barrier PW. Detailed description thereabout will be given below.

A display panel according to a comparative example may include a light emitting element formed in a barrier opening of a conductive barrier and may include a lower inorganic encapsulation pattern covering the light emitting element and having a cantilever shape. However, according to embodiments of the present disclosure, the light emitting element OLED may be formed on the conductive barrier PW rather than in the outer barrier opening OP-PO of the conductive barrier PW, and thus the occurrence of a shadow area during a deposition process may be effectively prevented. Accordingly, embodiments of the present disclosure may provide the display panel DP capable of easily implementing high resolution. In addition, a lower inorganic encapsulation pattern LIL covering the light emitting element OLED formed on the conductive barrier PW may be more stable and robust, and since the light emitting element OLED is not disposed in the outer barrier opening OP-PO, the thickness of the conductive barrier PW may be reduced.

The auxiliary electrode SE may be disposed on the second electrode CE. The auxiliary electrode SE may cover the second electrode CE and may make direct contact with the conductive barrier PW. The auxiliary electrode SE may make contact with a lower surface B-L2 of the second barrier layer L2 and the first outer surface OS-L1 of the first barrier layer L1. In an embodiment, for example, the auxiliary electrode SE may cover the second electrode CE and may extend along the lower surface B-L2 of the second barrier layer L2 and the first outer surface OS-L1 of the first barrier layer L1. However, this is illustrative, and the shape of the auxiliary electrode SE is not limited thereto. In another embodiment, the auxiliary electrode SE may include a portion that covers the second electrode CE and the lower surface B-L2 of the second barrier layer L2 and a portion that does not extend from the lower surface B-L2 of the second barrier layer L2 and makes contact with the first outer surface OS-L1 of the first barrier layer L1.

The auxiliary electrode SE may include a conductive material. In an embodiment, for example, the conductive material may include metal, transparent conductive oxide (TCO), or a combination thereof. In an embodiment, for example, the metal may include gold (Au), silver (Ag), aluminum (Al), magnesium (Mg), lithium (Li), molybdenum (Mo), titanium (Ti), copper (Cu), or an alloy. The transparent conductive oxide may include indium tin oxide (ITO), indium zinc oxide (IZO), zinc oxide, indium oxide, indium gallium oxide, indium gallium zinc oxide (IGZO), or aluminum zinc oxide.

The auxiliary electrode SE may make contact with the second electrode CE and the conductive barrier PW and may electrically connect the second electrode CE and the conductive barrier PW. The conductive barrier PW may receive a driving voltage (or a bias voltage), and accordingly the second electrode CE may receive the driving voltage (or the bias voltage).

The display element layer DP-OLED may further include a pixel defining layer PDL. The pixel defining layer PDL may be disposed on the barrier insulating layer IP. The pixel defining layer PDL may have the light emitting opening OP-E that exposes at least a portion of the first electrode AE. The light emitting opening OP-E may overlap (or correspond to) the first electrode AE, and the pixel defining layer PDL may expose at least a portion of the first electrode AE through the light emitting opening OP-E. When viewed from above the plane or in a plan view, the light emitting opening OP-E may have a ring shape. The light emitting opening OP-E may correspond to the third light emitting area PXA-B.

The pixel defining layer PDL may include an inorganic insulating material. In an embodiment, for example, the inorganic insulating material may include silicon nitride (SiNx).

The pixel defining layer PDL may be disposed in the inner barrier opening OP-PI. When viewed from above the plane or in a plan view, the inner barrier opening OP-PI may correspond to the light extraction area LGA. The pixel defining layer PDL may provide a flat surface to the area corresponding to the inner circle of the light emitting opening OP-E. In an embodiment, for example, when viewed from above the plane or in a plan view, the pixel defining layer PDL may provide a flat surface to the light extraction area LGA.

When the pixel defining layer PDL is not disposed in the inner barrier opening OP-PI unlike in the present disclosure, the area corresponding to the inner barrier opening OP-PI may also operate as a light emitting area. Due to the inclined surface of the inner barrier opening OP-PI, the emission pattern EP may not be deposited to have a constant thickness, and therefore it may be difficult to secure a uniform amount of emitted light in the light emitting area. However, according to embodiments of the present disclosure, the pixel defining layer PDL may be disposed on the first electrode AE. The pixel defining layer PDL may be filled in the inner barrier opening OP-PI. The upper surface of the first electrode AE that makes contact with the emission pattern EP in the third light emitting area PXA-B may have a flat surface. The emission pattern EP disposed on the upper surface of the first electrode AE may be deposited to have a constant or uniform thickness. The light emitting element OLED may secure uniform light emission in the third light emitting area PXA-B. Accordingly, embodiments of the present disclosure may provide the display panel DP with improved display quality.

In a case where the pixel defining layer PDL is not disposed in the inner barrier opening OP-PI unlike in the present disclosure, a short circuit may occur between the conductive barrier PW and the first electrode AE if particles exist in the inner barrier opening OP-PI in the manufacturing process. However, according to embodiments of the present disclosure, the pixel defining layer PDL may be disposed on the first electrode AE and may be filled in the inner barrier opening OP-PI. In the inner barrier opening OP-PI, the pixel defining layer PDL may be disposed between the conductive barrier PW and the first electrode AE. The conductive barrier PW and the first electrode AE may be insulated from each other. Accordingly, the present disclosure may provide the display panel DP with improved reliability.

The display element layer DP-OLED may further include a protrusion PT and a light control layer LG.

The protrusion PT may be disposed on the pixel defining layer PDL. The protrusion PT may overlap the center of the emission pattern EP. The protrusion PT may protrude from the pixel defining layer PDL in the third direction DR3.

When viewed from above the plane or in a plan view, the protrusion PT may overlap the inner barrier opening OP-PI.

The protrusion PT may include an organic material or an inorganic material. In an embodiment, for example, the protrusion PT may be integrally formed with the pixel defining layer PDL. In such an embodiment, the pixel defining layer PDL and the protrusion PT may be formed through a same process. However, this is illustrative, and the protrusion PT according to an embodiment of the present disclosure is not limited thereto. In an embodiment, for example, the protrusion PT may include a material different from the material of the pixel defining layer PDL.

The side surface of the protrusion PT may have an inclined surface SS. The inclined surface SS may have a certain angle from a plane. In an embodiment, for example, the certain angle may be about 45 degrees or greater.

The light control layer LG may be disposed on the protrusion PT. The light control layer LG may cover the protrusion PT. The light control layer LG may overlap the center of the emission pattern EP.

The light control layer LG may include a metallic material or a material having a second refractive index. The material having the second refractive index may include SiO₂, MgF₂, and LiF. However, this is illustrative, and the material according to an embodiment of the present disclosure is not limited thereto. SiO₂ may have a refractive index of about 1.45 to about 1.5. MgF₂ may have a refractive index of about 1.38. LiF may have a refractive index less than about 1.4. The light control layer LG may have the second refractive index. The second refractive index may be lower than the first refractive index of the emission pattern EP. In an embodiment, for example, the second refractive index may be about 1.5 or less.

Due to the inclined surface SS, light output from the third light emitting area PXA-B may be reflected by the light control layer LG and may be provided to the light extraction area LGA in a direction parallel to the third direction DR3.

The light may be provided to the light extraction area LGA along a light extraction path GL1. When viewed from above the plane or in a plan view, the light extraction area LGA may overlap the inner barrier opening OP-PI. The protrusion PT and the light control layer LG may be disposed in the light extraction area LGA.

To secure a uniform amount of emitted light, the pixel defining layer PDL may be filled in the inner barrier opening OP-PI. Due to this, when viewed from above the plane or in a plan view, the third light emitting area PXA-B may have a ring shape. The light extraction area LGA may correspond to the inner circle of the ring shape.

According to embodiments of the present disclosure, the third light emitting area PXA-B may provide light by the area where the first electrode AE and the emission pattern EP make contact with each other. The light extraction area LGA may reflect the light output from the third light emitting area PXA-B by the light control layer LG and may provide the light along the light extraction path GL1. When viewed from above the plane or in a plan view, each of the plurality of pixels PX (refer to FIG. 8) may emit light through the third light emitting area PXA-B and the light extraction area LGA. The light emission area of each of the plurality of pixels PX (refer to FIG. 8) may be increased. The luminance may be compensated for by the increased light emission area. Accordingly, the present disclosure may provide the display panel DP with improved display quality.

The thin film encapsulation layer TFE may be disposed on the display element layer DP-OLED. The thin film encapsulation layer TFE may include the lower inorganic encapsulation pattern LIL, an organic encapsulation film OL, and an upper inorganic encapsulation film UIL.

The lower inorganic encapsulation pattern LIL may be formed to correspond to (or overlap) the light emitting opening OP-E or the inner barrier opening OP-PI. That is, the lower inorganic encapsulation pattern LIL may be formed to overlap the light emitting element OLED. The lower inorganic encapsulation pattern LIL may be disposed on the auxiliary electrode SE and may cover the auxiliary electrode SE. The lower inorganic encapsulation pattern LIL may be spaced apart from the common electrode BE on the cross-section.

The organic encapsulation film OL may be disposed on the lower inorganic encapsulation pattern LIL to cover the lower inorganic encapsulation pattern LIL and may provide a flat upper surface. A portion of the organic encapsulation film OL may fill the area (hereinafter, referred to as the dummy area) where the lower inorganic encapsulation pattern LIL and the common electrode BE are spaced apart from each other on the cross-section. However, the shape of the organic encapsulation film OL is illustrative and is not limited to the above example. In another embodiment, for example, the organic encapsulation film OL may not fill the dummy area, and the dummy area may remain as an empty space.

The upper inorganic encapsulation film UIL may be disposed on the organic encapsulation film OL. The upper inorganic encapsulation film UIL may include an inorganic material.

The lower inorganic encapsulation pattern LIL and the upper inorganic encapsulation film UIL may protect the display element layer DP-OLED from moisture/oxygen, and the organic encapsulation film OL may protect the display element layer DP-OLED from foreign matter such as dust particles.

In embodiments of the present disclosure, as described above, the light emitting area may provide light by the area where the first electrode and the emission pattern make contact with each other. The light extraction area may reflect the light output from the light emitting area by the light control layer and may provide the light along the light extraction path. When viewed from above the plane or in a plan view, each of the plurality of pixels may emit light through the light emitting area and the light extraction area. The light emission area of each of the plurality of pixels may be increased. The luminance may be compensated for by the increased light emission area. Accordingly, the present disclosure may provide the display device and the electronic device with improved display quality.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (DD) comprising:
a base layer (BL);
a circuit element layer (DP-CL) disposed on the base layer (BL), wherein the circuit element layer (DP-CL) includes a transistor (TR1); and
a display element layer (DP-OLED) disposed on the circuit element layer (DP-CL),
wherein the display element layer (DP-OLED) includes:
a common electrode (BE) disposed on the circuit element layer (DP-CL);
a conductive barrier (PW) disposed on the common electrode (BE), wherein the conductive barrier (PW) defines an outer barrier opening (OP-PO) and an inner barrier opening (OP-PI);
a barrier insulating layer (IP) disposed on the conductive barrier (PW);
a first electrode (AE) disposed on the barrier insulating layer (IP) and disposed in the inner barrier opening (OP-PI), wherein the first electrode (AE) is electrically connected to the transistor (TR1);
a pixel defining layer (PDL) disposed on the first electrode (AE), wherein a light emitting opening (OP-E) is defined in the pixel defining layer (PDL) to expose a portion of the first electrode (AE);
an emission pattern (EP) disposed on the first electrode (AE) and covering the pixel defining layer (PDL);
a second electrode (CE) covering the emission pattern (EP) and electrically connected with the conductive barrier (PW);
a protrusion (PT) disposed on the pixel defining layer (PDL) and overlapping a center of the emission pattern (EP); and
a light control layer (LG) disposed on the protrusion (PT) and covering the protrusion (PT).

2. The display device (DD) of claim 1, wherein
the emission pattern (EP) has a first refractive index, and
the light control layer (LG) has a second refractive index lower than the first refractive index.

3. The display device (DD) of any one of the preceding claims, wherein the light control layer (LG) includes a metallic material.

4. The display device (DD) of any one of the preceding claims, wherein the protrusion (PT) includes an organic material or an inorganic material.

5. The display device (DD) of any one of the preceding claims, wherein a side surface of the protrusion (PT) is inclined with respect to an upper surface of the base layer (BL).

6. The display device (DD) of any one of the preceding claims, wherein the protrusion (PT) overlaps the inner barrier opening (OP-PI) in a plan view.

7. The display device (DD) of any one of the preceding claims, wherein the inner barrier opening (OP-PI) overlaps the center of the emission pattern (EP).

8. The display device (DD) of any one of the preceding claims, wherein the inner barrier opening (OP-PI) overlaps the center of the first electrode (AE).

9. The display device (DD) of any one of the preceding claims, wherein the emission pattern (EP) covers a portion of the conductive barrier (PW) and the barrier insulating layer (IP).

10. The display device (DD) of any one of the preceding claims, wherein the light emitting opening (OP-E) has a ring shape in a plan view.

11. The display device (DD) of any one of the preceding claims, wherein the pixel defining layer (PDL) is filled in the inner barrier opening (OP-PI).

12. The display device according to any one of the preceding claims, wherein the outer barrier opening (OP-PO) comprises an undercut-shape in the cross section.

13. The display device of any one of the preceding claims, wherein the conductive barrier (PW) defines a tip portion therein, wherein the emission pattern (EP) is patterned by the tip portion and covers a side surface of the barrier insulating layer (IP)

14. The display device (DD) of any one of the preceding claims, further comprising:
a thin film encapsulation layer (TFE) disposed on the second electrode (CE).

15. An electronic device (ED) comprising:
a display device (DD) according to any one of the preceding claims; and
a processor which controls the display device (DD).
